# EUROPEAN PATENT SPECIFICATION

(11) **EP 2 223 421 B1**
(45) Date of publication and mention of the grant of the patent: **21.01.2015**
(21) Application number: 08869166.2
(22) Date of filing: 04.12.2008
(51) Int. Cl.: H02M 3/155, G06F 1/26

(54) **SELF-CONFIGURABLE MULTI-REGULATOR ASIC CORE POWER DELIVERY**
SELBSTKONFIGURIERBARE MULTIREGLER-STROMVERSORGUNG FÜR ASIC-KERNE
ALIMENTATION DE PUISSANCE DE BASE POUR ASIC MULTI-RÉGULATEUR AUTO-CONFIGURABLE

(30) Priority: 21.12.2007 US 5056; 21.12.2007 US 5126
(43) Date of publication of application: 01.09.2010
(73) Proprietor: SanDisk Technologies Inc., Plano, Texas 75024 (US)
(72) Inventor: CHI, Steve, X., Cupertino CA 95014 (US); WANG, Yongliang, Saratoga CA 95070 (US); BHUIYAN, Ekram, Hossain, San Jose CA 95131 (US); NGUYEN, Daniel, P., Campbell CA 95008 (US); CONDITO, Vincent, Anthony, San Jose CA 95112 (US); LAI, Po-shen, San Jose CA 95138 (US)
(74) Representative: Hitchcock, Esmond Antony
(86) International application number: PCT/US2008/085461
(87) International publication number: WO 2009/085549

(56) References cited:
- WO-A1-2006/062505
- WO-A1-2006/062505
- KR-A- 20070 029 693
- US-A- 6 097 241
- US-A- 6 097 241
- US-A1- 2007 288 772
- US-A1- 2007 288 772
- US-B2- 6 710 621
- VISHNU BALAN: 'A Low-Voltage Regulator Circuit With Self-Bias to Improve Accuracy' 2003 IEEE SOLID-STATE CIRCUIT JOURNAL vol. 38, no. 2, February 2003, pages 365 - 368, XP011065937
- BENJAMIN J. PATELLA ET AL.: 'High-Frequency Digital PWM Controller IC for DC-DC Converters' 2003 IEEE TRANSACTIONS ON POWER ELECTRONICS vol. 18, no. 1, January 2003, pages 438 - 446, XP011078286

## Description

The present disclosure relates generally to an ASIC core or similar electronic circuit that can be powered by various power regulator technologies selected "on the fly" depending upon the actual application in which it is used.

An ASIC (Application Specific Integrated Circuit) is a semiconductor device designed for a particular application. ASICs may include virtually any collection of circuits known. For example, they are used in consumer memory devices such as those used with cameras, music players, navigation devices and the like. They are also used in many other types of electronic devices and may be highly specialized to a particular task or set of tasks.

An AISC core is a defined function to be performed by circuitry which has been designed and verified as a standalone entity and is available in an ASIC function library for a particular process technology. Each ASIC core is an element whose performance and function are understood and which can be, essentially, used as a building block in constructing an ASIC chip design. An ASIC core may be implemented as a function plus a predefined physical layout or standard cell, a function plus a physical layout to be implemented by the ASIC vendor, or as a function embodied in a standard technology-dependent gate-level net list to be fully integrated by the customer.

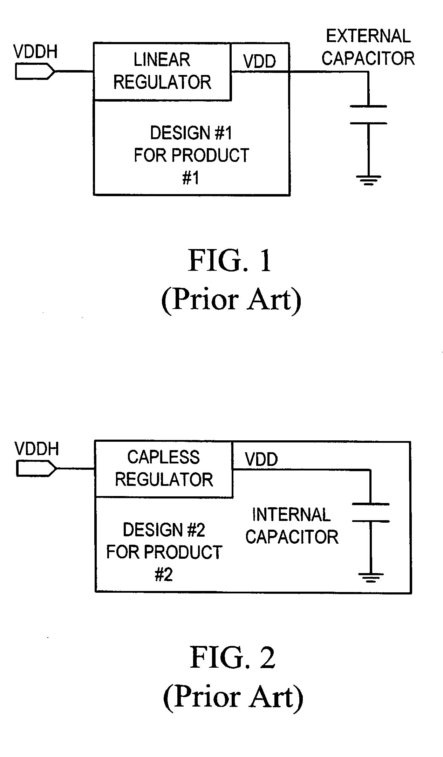

ASIC cores, when implemented as real circuits, require regulated power in order to operate. Typically they are powered by one of the available various regulator technologies depending upon the needs of the circuit. For example, for applications requiring extremely low quiescent and active operating current but which can tolerate the use of an external (i.e., relatively large) capacitor, a linear (e.g., low dropout (LDO)) regulator is highly suitable. Such an approach is used, for example, in micro secure digital (SD) memory cards and is illustrated in block diagram form in FIG. 1. On the other hand, if board space (or other physical space) is at a premium and higher quiescent and active operating currents are tolerable, then a capless regulator having no external capacitor may be a better solution. This situation is often encountered in high-end memory card application (e.g., Memory Stick-type Flash memory cards, and the like) and is illustrated in block diagram form in FIG. 2.

The design, validation and construction of ASIC chips represents a significant investment for an electronic product manufacturer. It would be desirable to reduce such costs to the extent possible.
US 6,097,241 discloses a method of operating an electronic apparatus and an electronic apparatus according to the pre-characterising portions of the independent claims respectively.
According to an aspect of the present invention there is provided a method for operating an electronic apparatus. The apparatus includes an application specific semiconductor chip device, hereinafter referred to as ASIC device, a linear regulator module configured to be optionally coupled to an external -to-the-ASIC device capacitor via a node and a capless regulator module coupled to an internal capacitance of the electronic apparatus via the node. The capless regulator module includes a low-power-sub-module and a high-power-sub-module. The high-power-sub-module is configured to provide a greater amount of electrical current than the low-power-sub-module. The method comprises applying power initially to the ASIC device via the node with the low-power sub module of the capless regulator module to initiate ASIC device power-up and detecting whether or not an external capacitance is coupled to the node.
According to another aspect of the present invention there is provided an electronic apparatus comprising an application specific semiconductor chip, hereinafter referred to as ASIC device, a linear regulator module configured to be optionally coupled in operation to an external-to-the-ASIC device capacitor via a node and a capless regulator module coupled to an internal capacitance of the electronic apparatus via the node. The capless regulator module includes a low-power sub-module and a high-power sub-module. The high-power sub-module is configured to provide a larger amount of electrical current than the low-power sub-module and control logic executable by the ASIC device. The control logic configured to detect the presence of the optional external capacitance and responsive thereto configured to select for use during a power-up phase of the ASIC at least the high-power sub-module of the capless regulator module if the optional external-to-the-ASIC device capacitor is detected.

A method for operating an electronic product having an application specific integrated circuit (ASIC) device is disclosed which includes in its circuitry both a linear regulator module configured to be coupled to an optional external capacitance and a capless regulator module coupled to internal capacitance of the electronic product selects one of a low-power sub-module or a high-power sub-module of the capless regulator module for use in a power-up phase of the ASIC. Control logic of the ASIC device determines if an external capacitance is present. If it is, then the control logic causes the high-power capless regulator sub-module to be used during a power-up phase of the ASIC. Otherwise only the low-power capless regulator sub-module is used during a power-up phase of the ASIC. After power-up of the ASIC, the control logic may select the linear regulator module for certain times of operating and the capless regulator module for other times of operation or it may select one or the other for all times of post-power-up operation.

An electronic product is disclosed that includes an application specific integrated circuit (ASIC) device which includes in its circuitry both a linear regulator module configured to be coupled to an optical external capacitance and a capless regulator coupled to internal capacitance of the electronic product. At least the capless regulator module includes both a low-power sub-module and a high-power sub-module. Control logic of the ASIC device is configured to determine if an external capacitance is present. If it is, then the control logic causes the high-power capless regulator sub-module to be used during a power-up phase of the ASIC. Otherwise only the low-power capless regulator sub-module is used during a power-up phase of the ASIC. After power-up of the ASIC, the control logic may select the linear regulator module for certain times of operation and the capless regulator module for other times of operation or it may select one or the other for all times of post-power-up operation.

The accompanying drawings, which are incorporated into and constitute a part of this specification, illustrate one or more examples of embodiments and, together with the description of example embodiments, serve to explain the principles and implementations of the embodiments.
FIG. 1 is a schematic block diagram for a first electronic product powered by a linear voltage regulator employing an external (relatively large) capacitance in accordance with the known art.
FIG. 2 is a schematic block diagram for a second electronic product powered by a linear voltage regulator employing an internal (relatively small) capacitance in accordance with the known art.
FIG. 3 is a schematic block diagram of an example memory device including a flash memory array, a controller ASIC device and interface(s) to a host device.
FIG. 4 is a schematic block diagram of a power supply portion of a third electronic product selectively powerable by a linear regulator module or a capless regulator module and including an external capacitor detector in accordance with one embodiment.
FIG. 5 is a schematic block diagram of a linear regulator module in accordance with one embodiment.
FIG. 6 is a schematic block diagram of a capless regulator module in accordance with one embodiment.
FIG. 7 is a schematic block diagram of control logic controlling a capless regulator module in accordance with one embodiment.
FIGS. 8-1, 8-2 and 8-3 together constitute a process flow diagram illustrating a method in accordance with one embodiment.

Example embodiments are described herein in the context of an electronic product including an ASIC device. Those of ordinary skill in the art will realize that the following description is illustrative only and is not intended to be in any way limiting. Other embodiments will readily suggest themselves to such skilled persons having the benefit of this disclosure. Reference will now be made in detail to implementations of the example embodiments as illustrated in the accompanying drawings. The same reference indicators will be used throughout the drawings and the following description to refer to the same or the like items.

In the interest of clarity, not all of the routine features of the implementations described herein are shown and described. It will, of course, be appreciated that in the development of any such actual implementation, numerous implementation-specific decisions must be made in order to achieve the developer's specific goals, such as compliance with application - and business - related constraints, and that these specific goals will vary from one implementation to another and from one developer to another. Moreover, it will be appreciated that such a development effort might be complex and time-consuming, but would nevertheless be a routine undertaking of engineering for those of ordinary skill in the art having the benefit of this disclosure.

In accordance with this disclosure, the components, process steps, and/or data structures described herein may be implemented using various types of operating systems, computing platforms, computer programs, and/or general purpose machines, e.g., in a controller of a non-volatile memory device. In addition, those of ordinary skill in the art will recognize that devices of a less general purpose nature, such as hardwired devices, field programmable gate arrays (FPGAs), application specific integrated circuits (ASICs), or the like, may also be used without departing from the scope of the inventive concepts disclosed herein. Where a method comprising a series of process steps is implemented by a computer or a machine and those process steps can be stored as a series of instructions readable by the machine, they may be stored on a tangible medium such as a computer memory device (e.g., ROM (Read Only Memory), PROM (Programmable Read Only Memory), EEPROM (Electrically Eraseable Programmable Read Only Memory), FLASH Memory, and the like), magnetic storage medium (e.g., tape, magnetic disk drive, and the like), optical storage medium (e.g., CD-ROM, DVD-ROM, paper card, paper tape and the like) and other types of program memory.

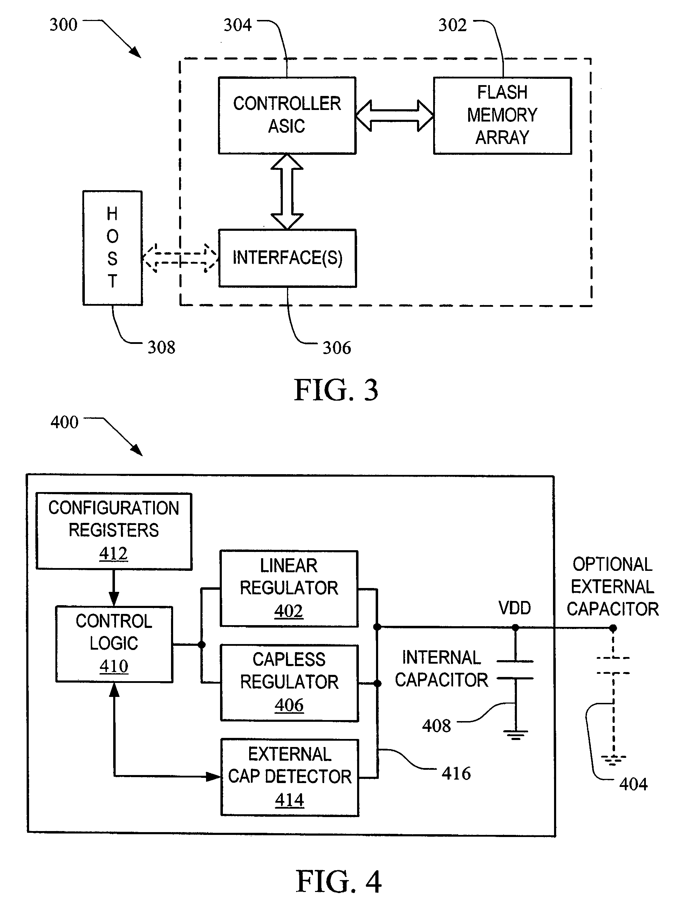

In accordance with one example embodiment, the invention may be used in a memory device useable with consumer electronic equipment such as computers, digital cameras, digital music players, navigation equipment, communications equipment, and the like. It may also be employed in other electronic products as will now be apparent to those of ordinary skill in the art. FIG. 3 illustrates a typical system block diagram of such a memory device. In the example memory device 300 of FIG. 3 a flash memory array 302 is controlled by a controller device 304 implemented as an ASIC device. Interface circuitry 306 is coupled to the controller 304 and provides connectivity to conventional host devices 308 to which memory device 300 may be coupled.

In the example memory device context, controller 304 is typically powered by an external device, such as the host device 308 and includes power supply circuitry such as that illustrated in FIGS. 1 and 2 in order to condition electrical power provided for use by its circuitry.

Turning now to FIG. 4, in accordance with one embodiment, a power circuit 400 includes a linear regulator module 402 (which requires coupling to an external-to-the-ASIC capacitor 404 of relatively high capacitance (on the order of one or more microfarads of capacitance)) as well as a "capless" regulator module 406 (which requires to external capacitor and makes do with a very small discrete decoupling capacitor or with the capacitance inherent in the circuitry of the ASIC 408 (on the order of 0.5 nF to a few nF (nanofarads) of capacitance)) both provided on the ASIC. An ASIC built in accordance with this concept may now be used in more than one application and the costs of development of the ASIC may be spread over a much larger potential market. For example, one ASIC may be used to build memory devices compatible with the micro SD standard as well as memory devices compatible with the Memory Stick standard even though such disparate devices would be expected to use different capacitor arrangements. External capacitors may be employed, or not, as required by the electrical design.

So called "capless" regulators are well known in the art. For example, an integrated linear regulator using only a 0.6 nF decoupling capacitor is described in detail in Hazucha et al., Area-Efficient Linear Regulator With Ultra-Fast Load Recognition, IEEE Journal of Solid State Circuits, Vol. 40, No. 4 (April 2005). Such circuits use extremely small capacitance - either provided by discrete but low-valued capacitors integrated onto the semiconductor die along with the rest of the regulator circuitry or the inherent parasitic capacitance of that circuitry. Typically these capacitances range from roughly 0.5 nF to a few nF.

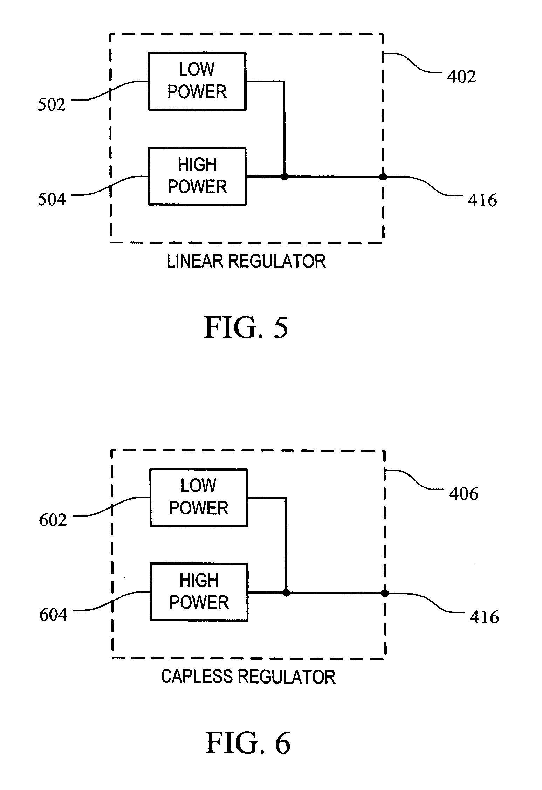

Linear regulator module 402 is depicted in some more detail in FIG. 5 where it is illustrated to comprise a low-power sub-module 502 (for providing relatively low power in a standby mode, for example) and high-power sub-module 504 (for providing relatively high power in a regular operating mode). In one example embodiment the low-power sub-module may provide electrical current up to about 5mA and the high-power module may provide electrical current up to about 100mA. One is typically selected for use at a time, or the low-power sub-module may be left on at all times and supplemented by the high-power sub-module when required.

Capless regulator module 406 is depicted in some more detail in FIG. 6 where it is illustrated to comprise a low-power sub-module 602 (for providing relatively low power in a standby mode, for example) and a high-power sub-module 604 (for providing relatively high power in a regular operating mode). In one example embodiment the low-power sub-module may provide electrical current up to about 5mA and the high-power sub-module may provide electrical current up to about 100mA. One is typically selected for use at a time, or the low-power sub-module may be left on at all times and supplemented by the high-power sub-module when required.

If a capless regulator is used in the product, only internal capacitance is present which is on the order of nanofarads. On the other hand, a much larger capacitance on the order of micro farad or so will be present if the linear regulator is configured for use in the product (with the presence of an external capacitance). The range of potential capacitance values is then on the order of 200x or more. If not controlled, this means that the slew rate of the core voltage will vary by the same wide margin. It is possible that in one worst case the voltage could ramp up on the order of nanoseconds, triggering an ESD (electrostatic discharge) protection (clamp) device which could effectively prevent the controller from powering up. Alternatively, in another worst case if the ramp rate is too slow, specified minimum thresholds for product wake-up might be violated leading the host to conclude that the device is inoperative. This is solved in one embodiment by using by default low-power sub-module 602 of the capless regulator module 402 (which avoids an ESD clamp) unless overridden by one of the techniques discussed below.

Turning back to FIG. 4, power circuit 400 includes control logic 410 executable by the ASIC 304 which is configured to access configuration registers 412. Configuration registers 412 (which may be implemented in the controller or in flash memory array 302) may store information which may be used to determine a post-power-up initial selection of one of the two regulator modules. In one embodiment the configuration registers may be configured to disable operation of the external capacitor detector 414 (described in more detail below) for more flexibility.

Since the low-power sub-module of the capless regulator module is stable without the presence of an external capacitor by default (it is designed that way), its low-power sub-module is automatically initially selected to provide power to the ASIC core during power-up. If external capacitance is then detected during power-up, then it is also safe to use the high-power sub-module of the capless regulator module to speed up the VDD_core ramp rate because the external capacitance will prevent the regulator from ramping too quickly.

To accomplish this, the external capacitor detector 414 is coupled to node 416 (VDD_core) to which is also coupled the internal capacitance 408 (sometimes referred to as parasitic capacitance), and (optionally) an external capacitance 404. Ideally where an external capacitance is present, it will in many cases be desirable to force the circuitry to utilize the linear regulator module 402 rather than the capless regulator module 406. By verifying the presence (or absence) of external capacitor 404, external capacitor detector 414 now makes that possible, thus avoiding in some embodiments the potential for harm due to accidental misconfiguration of ASICs at the factory (e.g., as by accidentally setting the configuration registers to tell the ASIC that an external capacitor is present (or absent) when in fact it is absent (or present)).

Operation of an external capacitor detector 414 in accordance with one embodiment is now discussed in more detail. The external capacitor detector 414 includes a pulse generator 702, a first and second latching output comparator (704, 706) and associated logic (708) to control the core regulator's ramp rate. The sequence of events following he initiation of power-up are:
1) A 'Discharge_en' (discharge enable) pulse on line 710 is generated briefly (in one embodiment a pulse width of about 20µSec is used) to briefly discharge VDD_core 712 (the core VDD regulated supply). This is done by turning on the gate of FET (field effect transistor) 714 which has the effect of coupling node 416 to ground 716. The intent is to couple VDD_core 712 briefly to ground 716 to see if it will discharge during the brief time.
2) If the 'LowRef' comparator 706 output 706o (comparing VDD_core on input 706a with Discharge_en on input 706b) indicates that the VDD_core 712 level is still high after the brief discharge cycle, it is then assumes that an off-chip capacitor 404 having microfarads of capacitance is present (because the brief discharge cycle would have discharged any charge on a much smaller internal capacitance). As a result, both the high-power and low-power sub-modules of the capless regulator module are enabled for operation (HP_en and LP_en are set to enable) to speed up the VDD ramp rate (this is safe to do because of the detected presence of the capacitor).
3) If, instead, the 'LowRef' comparator 706 output 706o indicates that VDD_core is now low after discharge indicating the possible lack of an external capacitor 404 (VDD_core may have started low and an external capacitor thus still may or may not be present), then 'LP_en' is set to enable so as to use the low-power sub-module of the capless regulator module for ramping up the VDD_core 712 power supply level.
4) Next, the 'CharEv_en' (charge evaluation pulse) signal is generated after a few microseconds (µSecs) to sense the VDD_core voltage level once again. If the 'HighRef' comparator output 704o now indicates that the VDD_core level is high, that indicates that only on-chip capacitance is present (i.e., there is no external capacitance) because of the quick ramp from low to high and thus only the low-power capless regulator module will be enabled during power-up. Otherwise the high-power sub-module of the capless regulator modulator will be enabled as well.

Once power-up of the ASIC core is completed (i.e., the VDD_core voltage is established), configuration information stored in the configuration registers at manufacture (accessible by the control logic of the ASIC - either on board the ASIC, on the flash memory array, or in another location) is read and based thereon, the ASIC control logic (which may be implemented by firmware executed by the control logic in the ASIC) selects the desired regulator for post power-up operation (either the linear regulator module or the capless regulator module). The desired regulator is then turned on (if not already on) and the other regulator is turned off (if it was one). Alternatively, the ASIC firmware may select one (or potentially both) of the two regulator modules for use after power-up based upon the earlier determination made during power-up of the presence or absence of an external capacitor described above. In yet another embodiment, conditions sensed during operation (e.g., current use, battery or input power state, and the like) may be used to select one of the two regulator modules "on the fly."

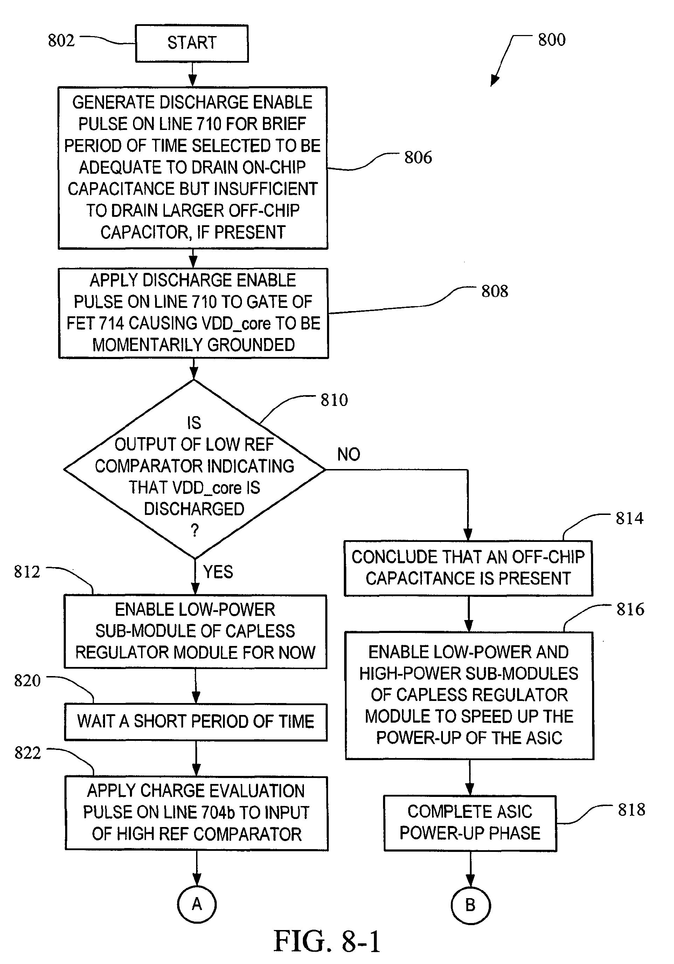

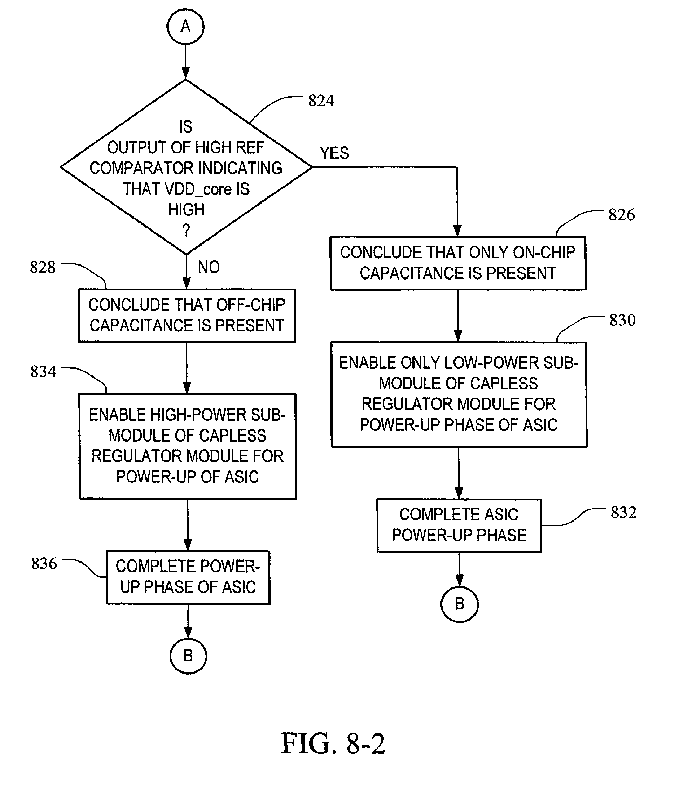

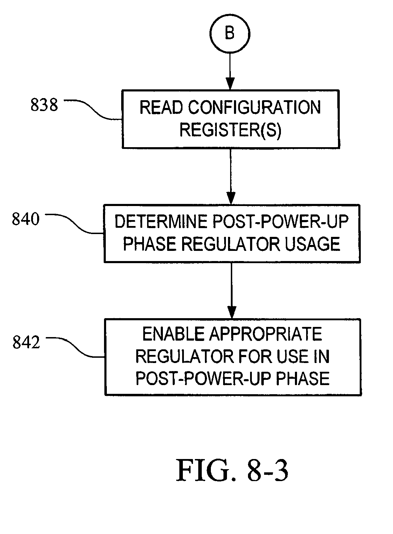

FIGS. 8-1, 8-2 and 8-3 together constitute a process flow diagram illustrating a method 800 in accordance with one embodiment. The method starts at block 802.

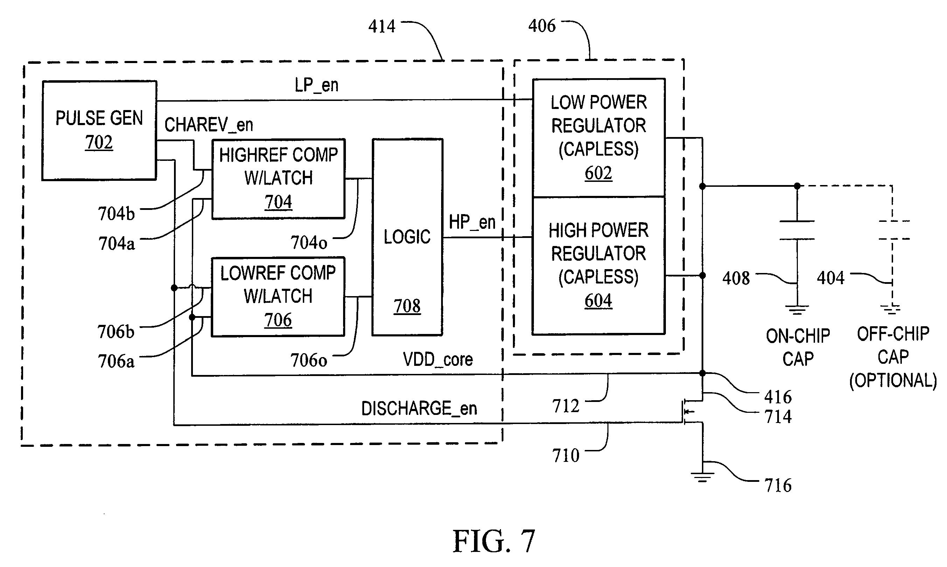

At block 806 a discharge enable pulse is generated on line 710 (FIG. 7) for a brief period of time selected to be adequate to discharge any on-chip capacitance but inadequate to discharge a larger optional off-chip capacitance (if present).

At block 808 the discharge enable pulse is applied over line 710 to the gate of FET 714 causing VDD_core momentarily to short to ground 716.

At decision block 810 the output 706o of the LowRef latching comparator 706 (determined by comparing inputs 706a (VDD_core) and 706b (discharge enable) is checked to see if VDD_core is discharged. If it is, control transfers to block 812; if not, control transfers to block 814.

At block 814 the conclusion is reached that an off-chip (large) capacitance 404 is present.

At block 816 the low-power 602 and high-power 604 sub-modules of capless regulator module 406 are enabled in order to provide more electrical current and thereby speed up the power-up of the ASIC.

At block 818 the power-up phase of the ASIC is completed and control transfers to Node B.

At block 812 it is still unclear as to whether or not an external capacitance 404 is present. Only the low-power sub-module 602 of the capless regulator module 406 will be used for now.

At block 820 the process waits a short period of time.

At block 822 a charge evaluation pulse is applied to the line 704b input to the HughRef Latching comparator 704 comparing it with VDD_core on input line 704a. Control transfers to Node A.

At decision block 824 the output 704o of HighRef comparator 704 is checked to see if it indicates that VDD_core is high. If it is (and that can only happen if a large capacitance is NOT present) then control transfers to block 826. Otherwise control transfers to block 828.

At block 826 it is concluded that only on-chip capacitance 408 is present and no off-chip (large) optional capacitor 404 is present.

At block 830 only the low-power sub-module of the capless regulator module is enabled for the power-up phase of the ASIC by logic block 708.

At block 832 the ASIC power-up phase is completed and control transfers to Node B.

At block 828 it is concluded that an off-chip capacitance 404 is present.

At block 834 logic block 708 enables the low-power 602 and high-power 604 submodules of the capless regulator module 406 for use in powering up the ASIC. This provides more current than the low-power sub-module alone and thus allows a faster power-up.

At block 836 the ASIC power-up phase is completed and control transfers to Node B.

At block 838 (reached from Node B) after power-up the control logic of the ASIC reads the configuration register(s).

At block 840 the post-power-up phase regulator usage is determined based upon the information read from the configuration register(s). For example, this could be, in effect, "Use Capless Regulator Module" or "Use Linear Regulator Module" and it could further specify whether to initially use the low-power of high-power sub-module of the respective regulator module, if desired.

At block 842, in response to the determination made in block 840, the appropriate regulator module (and possibly sub-module) for use in the post-power-up phase is enabled.

In another embodiment it is also possible to modify blocks 833, 840 and 842 so that instead of allowing configuration registers to select the post-power-up regulator module for use, the prior determination as to the presence or absence of an off-chip capacitance 404 would yield that decision, thus requiring no pre-configuration of the device in this regard.

Accordingly, a single ASIC device may now be fabricated and used in a wider array of products increasing its utility and decreasing overall development and per-part costs.

While embodiments and applications have been shown and described, it would be apparent to those skilled in the art having the benefit of this disclosure that many more modifications than mentioned above are possible without departing from the inventive concepts disclosed herein. For example, additional regulator modules and/or sub-modules may be provided and selected among.

## Claims

1. A method for operating an electronic apparatus (300, 400), the apparatus (300, 400) including an application specific semiconductor chip device hereinafter referred to as ASIC device and a linear regulator module (402) configured to be optionally coupled to an external-to-the-ASIC device capacitor (404) via a node, a capless regulator module (406) coupled to an internal capacitance (408) of the electronic apparatus (300, 400) via the node, the capless regulator module (406) including a low-power-sub-module (602) and a high-power-sub-module (604), the high-power-sub-module (604) configured to provide a greater amount of electrical current than the low-power-sub-module (602);
the method **characterised by**:
applying (806, 808) power initially to the ASIC device via the node with the low-power sub module (602) of the capless regulator module (406) to initiate ASIC device power-up;
detecting whether or not an external capacitor (404) is coupled to the node; and
subsequently applying power to the ASIC device via the node with the high-power sub-module (604) of the capless regulator module (406) in response to detection of an external-to-the-ASIC device capacitor (404) coupled to the node.

2. The method of claim 1, further comprising:
subsequently applying power to the ASIC device via the node with the low-power sub-module (602) of the capless regulator module (406) in response to detection of an absence of an external-to-the-ASIC device capacitor (404) coupled to the node.

3. The method of claim 1 or claim 2, further comprising: completing the power-up of the ASIC device.

4. The method of claim 1 or claim 2, further comprising:
selecting one of the linear regulator module (402) or the capless regulator module (406) to provide power to the ASIC device after power-up of the ASIC device.

5. The method of claim 4, wherein the selecting is responsive to a stored state of a configuration register (412) accessible by the ASIC device.

6. An electronic apparatus, comprising:
an application specific semiconductor chip, hereinafter referred to as, ASIC device;
a linear regulator module (402) configured to be optionally coupled in operation to an external-to-the-ASIC device capacitor (404) via a node; **CHARACTERISED BY**:
a capless regulator module (406) coupled to an internal capacitance (408) of the electronic apparatus via the node, the capless regulator module (406) including a low-power sub-module (602) and a high-power sub-module (604),
the high-power sub-module (604) configured to provide a larger amount of electrical current than the low-power sub-module (602); and
control logic (410) executable by the ASIC device, the control logic (410) configured to detect the presence of the optional external capacitance (408) and responsive thereto configured to select for use during a power-up phase of the ASIC at least the high-power sub-module (604) of the capless regulator module (406) if the optional external-to-the-ASIC device capacitor (408) is detected.

7. The apparatus of claim 6, wherein the control logic (410) is configured to select for use during the power-up phase of the ASIC device at least the low-power sub-module (602) of the capless regulator module (406).

8. The apparatus of claim 6, wherein the linear regulator module (402) includes at least a first (502) and a second (504) linear regulator sub-module, the first linear regulator sub-module (502) configured to provide up to a first level of electrical current and the second linear regulator sub-module (504) configured to provide up to a second level of electrical current,

9. The apparatus of claim 8, wherein the second level of electrical current is greater than the first level of electrical current.

10. The apparatus of claim 6, wherein the apparatus (300, 400) is initially configured to use the capless regulator module (406) prior for providing power to power-up the ASIC device during at least a portion of the power-up phase of the ASIC device.

11. The apparatus of claim 6, wherein the apparatus (300, 400) is initially configured to use the low-power sub-module (602) of the capless regulator module for providing power to power-up the ASIC device during at least a portion of the power-up phase of the ASIC device.

12. The apparatus of claim 6, wherein the control logic (410) is configured to detect the presence of the optional external-to-the-ASIC device capacitor (408) at least in part by discharging the node.

13. The apparatus of claim 6, wherein the control logic (410) is configured to detect the presence of the optional external-to-the-ASIC device capacitor (408) at least in part by charging the node.

14. The apparatus of claim 6, wherein the control logic (410) is configured to detect the presence of the optional external-to-the-ASIC device capacitor (408) at least in part by both discharging and subsequently charging the node.

## Patentansprüche

1. Verfahren zum Operieren eines elektronischen Geräts (300, 400), das Gerät (300, 400) enthaltend eine anwendungsspezifische Halbleiterchipvorrichtung, im Folgenden als eine ASIC-Vorrichtung bezeichnet, und ein lineares Reglermodul (402), konfiguriert, wahlweise an einen Extern-zur-ASIC-Vorrichtung-Kondensator (404) über einen Knoten gekoppelt zu werden, ein kappenloses Reglermodul (406), gekoppelt an eine interne Kapazität (408) des elektronischen Geräts (300, 400) über den Knoten, wobei das kappenlose Reglermodul (406) ein Untermodul niedriger Leistung (602) und ein Untermodul hoher Leistung (604) enthält, das Untermodul hoher Leistung (604) konfiguriert zum Bereitstellen einer größeren Menge von elektrischem Strom als das Untermodul niedriger Leistung (602);
das Verfahren **gekennzeichnet durch**:
Anlegen (806, 808) von Leistung anfänglich an die ASIC-Vorrichtung über den Knoten **durch** das Untermodul niedriger Leistung (602) des kappenlosen Reglermoduls (406) um das Hochfahren der ASIC-Vorrichtung einzuleiten;
Detektieren, ob ein externer Kondensator (404) an den Knoten gekoppelt ist; und
anschließend Anlegen von Leistung an die ASIC-Vorrichtung über den Knoten durch das Untermodul hoher Leistung (604) des kappenlosen Reglermoduls (406) als Reaktion auf Detektion eines Extern-zur-ASIC-Vorrichtung-Kondensators (404), der an den Knoten gekoppelt ist.

2. Verfahren nach Anspruch 1, ferner umfassend:
anschließend Anlegen von Leistung an die ASIC-Vorrichtung über den Knoten, durch das Untermodul niedriger Leistung (602) des kappenlosen Reglermoduls (406) als Reaktion auf Detektion einer Abwesenheit eines Extern-zur-ASIC-Vorrichtung-Kondensators (404), der an den Knoten gekoppelt ist.

3. Verfahren nach Anspruch 1 oder Anspruch 2, ferner umfassend:
Fertigstellen des Hochfahrens der ASIC-Vorrichtung.

4. Verfahren nach Anspruch 1 oder Anspruch 2, ferner umfassend:
Auswählen eines des linearen Reglermoduls (402) oder des kappenlosen Reglermoduls (406) zum Bereitstellen von Leistung für die ASIC-Vorrichtung nach dem Hochfahren der ASIC-Vorrichtung.

5. Verfahren nach Anspruch 4, wobei das Auswählen eine Reaktion auf einen gespeicherten Zustand eines Konfigurationsregisters (412) ist, auf das die ASIC-Vorrichtung zugreifen kann.

6. Elektronisches Gerät, umfassend:
ein anwendungsspezifischer Halbleiterchip, im Folgenden als ASIC-Vorrichtung bezeichnet;
ein lineares Reglermodul (402), konfiguriert, um wahlweise im Betrieb an einen Extern-zur-ASIC-Vorrichtung-Kondensator (404) über einen Knoten gekoppelt zu werden;
**gekennzeichnet durch**:
ein kappenloses Reglermodul (406), gekoppelt an eine interne Kapazität (408) des elektronischen Geräts über den Knoten, wobei das kappenlose Reglermodul (406) ein Untermodul niedriger Leistung (602) und ein Untermodul hoher Leistung (604) enthält, das Untermodul hoher Leistung (604) konfiguriert zum Bereitstellen einer größeren Menge von elektrischem Strom als das Untermodul niedriger Leistung (602); und
Steuerlogik (410), ausführbar **durch** die ASIC-Vorrichtung, die Steuerlogik (410) konfiguriert zum Detektieren des Vorhandenseins der wahlweisen externen Kapazität (408) und als Reaktion darauf konfiguriert zum Auswählen, zur Verwendung während einer Hochfahrphase der ASIC, mindestens des Untermoduls hoher Leistung (604) des kappenlosen Reglermoduls (406), wenn der wahlweise Extern-zur-ASIC-Vorrichtung-Kondensator (408) detektiert wird.

7. Gerät nach Anspruch 6, wobei die Steuerlogik (410) konfiguriert ist zum Auswählen, zur Verwendung während der Hochfahrphase der ASIC-Vorrichtung, mindestens des Untermoduls niedriger Leistung (602) des kappenlosen Reglermoduls (406).

8. Gerät nach Anspruch 6, wobei das lineare Reglermodul (402) mindestens ein erstes (502) und ein zweites (504) lineares Regleruntermodul enthält, wobei das erste lineare Regleruntermodul (502) konfiguriert ist zum Bereitstellen von elektrischem Strom bis zu einem ersten Pegel und das zweite lineare Regleruntermodul (504) konfiguriert ist zum Bereitstellen von elektrischem Strom bis zu einem zweiten Pegel.

9. Gerät nach Anspruch 8, wobei der zweite Pegel von elektrischem Strom größer ist als der erste Pegel von elektrischem Strom.

10. Gerät nach Anspruch 6, wobei das Gerät (300, 400) anfänglich konfiguriert ist zum vorherigen Verwenden des kappenlosen Reglermoduls (406) zum Bereitstellen von Leistung zum Hochfahren der ASIC-Vorrichtung während mindestens eines Abschnitts der Hochfahrphase der ASIC-Vorrichtung.

11. Gerät nach Anspruch 6, wobei das Gerät (300, 400) anfänglich konfiguriert ist zum Verwenden des Untermoduls niedriger Leistung (602) des kappenlosen Reglermoduls zum Bereitstellen von Leistung zum Hochfahren der ASIC-Vorrichtung während mindestens eines Abschnitts der Hochfahrphase der ASIC-Vorrichtung.

12. Gerät nach Anspruch 6, wobei die Steuerlogik (410) konfiguriert ist zum Detektieren des Vorhandenseins des wahlweisen Extern-zur-ASIC-Vorrichtung-Kondensators (408) mindestens teilweise durch Entladen des Knotens.

13. Gerät nach Anspruch 6, wobei die Steuerlogik (410) konfiguriert ist zum Detektieren des Vorhandenseins des wahlweisen Extern-zur-ASIC-Vorrichtung-Kondensators (408) mindestens teilweise durch Laden des Knotens.

14. Gerät nach Anspruch 6, wobei die Steuerlogik (410) konfiguriert ist zum Detektieren des Vorhandenseins des wahlweisen Extern-zur-ASIC-Vorrichtung-Kondensators (408) mindestens teilweise durch sowohl Entladen als auch anschließendem Laden des Knotens.

## Revendications

1. Procédé pour mettre en oeuvre un appareil électronique (300, 400), l'appareil (300, 400) comprenant un dispositif à puce semi-conductrice spécifique à une application appelé ci-après dispositif ASIC et un module de régulateur linéaire (402) configuré pour être couplé, en option, à un condensateur (404) à l'extérieur du dispositif ASIC par l'intermédiaire d'un noeud, un module de régulateur sans condensateur (406) couplé à une capacitance interne (408) de l'appareil électronique (300, 400) par l'intermédiaire du noeud, le module de régulateur sans condensateur (406) comprenant un sous-module faible puissance (602) et un sous-module forte puissance (604), le sous-module forte puissance (604) étant configuré pour fournir une plus grande quantité de courant électrique que le sous-module faible puissance (602) ;
le procédé étant **caractérisé par** :
l'application (806, 808) d'une puissance initialement au dispositif ASIC par l'intermédiaire du noeud par le sous-module faible puissance (602) du module de régulateur sans condensateur (406) pour débuter la mise sous tension du dispositif ASIC ;
la détection si, oui ou non, un condensateur externe (404) est couplé au noeud ; et
l'application par la suite d'une puissance au dispositif ASIC par l'intermédiaire du noeud par le sous-module forte puissance (604) du module de régulateur sans condensateur (406) en réponse à la détection d'un condensateur (404) à l'extérieur du dispositif ASIC couplé au noeud.

2. Procédé selon la revendication 1, comprenant en outre :
l'application par la suite d'une puissance au dispositif ASIC par l'intermédiaire du noeud par le sous-module faible puissance (602) du module de régulateur sans condensateur (406) en réponse à la détection d'une absence d'un condensateur (404) à l'extérieur du dispositif ASIC couplé au noeud.

3. Procédé selon la revendication 1 ou la revendication 2, comprenant en outre :
l'achèvement de la mise sous tension du dispositif ASIC.

4. Procédé selon la revendication 1 ou la revendication 2, comprenant en outre :
la sélection de l'un du module de régulateur linéaire (402) ou du module de régulateur sans condensateur (406) pour fournir une puissance au dispositif ASIC après la mise sous tension du dispositif ASIC.

5. Procédé selon la revendication 4, dans lequel la sélection est fonction d'un état mémorisé d'un registre de configuration (412) accessible par le dispositif ASIC.

6. Appareil électronique, comprenant :
une puce semi-conductrice spécifique à une application, appelée ci-après dispositif ASIC;
un module de régulateur linéaire (402) configuré pour être couplé, en option, en fonctionnement à un condensateur (404) à l'extérieur du dispositif ASIC par l'intermédiaire d'un noeud ;
**caractérisé par** :
un module de régulateur sans condensateur (406) couplé à une capacitance interne (408) de l'appareil électronique par l'intermédiaire du noeud, le module de régulateur sans condensateur (406) comprenant un sous-module faible puissance (602) et un sous-module forte puissance (604), le sous-module forte puissance (604) étant configuré pour fournir une plus grande quantité de courant électrique que le sous-module faible puissance (602) ; et
une logique de commande (410) exécutable par le dispositif ASIC, la logique de commande (410) étant configurée pour détecter la présence de la capacitance externe (408) optionnelle et, en réponse à celle-ci, configurée pour sélectionner, pour une utilisation pendant une phase de mise sous tension de l'ASIC, au moins le sous-module forte puissance (604) du module de régulateur sans condensateur (406) si le condensateur (408) à l'extérieur du dispositif ASIC optionnel est détecté.

7. Appareil selon la revendication 6, dans lequel la logique de commande (410) est configurée pour sélectionner, pour une utilisation pendant la phase de mise sous tension du dispositif ASIC, au moins le sous-module faible puissance (602) du module de régulateur sans condensateur (406).

8. Appareil selon la revendication 6, dans lequel le module de régulateur linéaire (402) comprend au moins un premier (502) et un deuxième (504) sous-module de régulateur linéaire, le premier sous-module de régulateur linéaire (502) étant configuré pour fournir un courant électrique jusqu'à un premier niveau et le deuxième sous-module de régulateur linéaire (504) étant configuré pour fournir un courant électrique jusqu'à un deuxième niveau.

9. Appareil selon la revendication 8, dans lequel le deuxième niveau de courant électrique est supérieur au premier niveau de courant électrique.

10. Appareil selon la revendication 6, dans lequel l'appareil (300, 400) est configuré initialement pour utiliser le module de régulateur sans condensateur (406) avant de fournir une puissance pour mettre sous tension le dispositif ASIC pendant au moins une partie de la phase de mise sous tension du dispositif ASIC.

11. Appareil selon la revendication 6, dans lequel l'appareil (300, 400) est configuré initialement pour utiliser le sous-module faible puissance (602) du module de régulateur sans condensateur pour fournir une puissance pour mettre sous tension le dispositif ASIC pendant au moins une partie de la phase de mise sous tension du dispositif ASIC.

12. Appareil selon la revendication 6, dans lequel la logique de commande (410) est configurée pour détecter la présence du condensateur (408) à l'extérieur du dispositif ASIC optionnel au moins en partie en déchargeant le noeud.

13. Appareil selon la revendication 6, dans lequel la logique de commande (410) est configurée pour détecter la présence du condensateur (408) à l'extérieur du dispositif ASIC optionnel au moins en partie en chargeant le noeud.

14. Appareil selon la revendication 6, dans lequel la logique de commande (410) est configurée pour détecter la présence du condensateur (408) à l'extérieur du dispositif ASIC optionnel au moins en partie à la fois en déchargeant et en chargeant par la suite le noeud.
